# EUROPEAN PATENT APPLICATION

(11) **EP 4 776 769 A1**
(43) Date of publication of application: **15.07.2026**
(21) Application number: 25211637.1
(22) Date of filing: 28.10.2025
(51) Int. Cl.: H05K 7/20, H10W 40/47, H10W 40/77

(54) **LIQUID MULTI-NOZZLE JET-IMPINGEMENT COOLING DEVICE**

(30) Priority: 13.01.2025 US 202519019400
(71) Applicant: Cooler Master Co., Ltd., Taipei City 114065 (TW); National Yang Ming Chiao Tung University, Hsinchu City 30010 (TW)
(72) Inventor: FULPAGARE, Yogesh Shantaram, 114065 Taipei City (TW); WANG, Chi-Chuan, 114065 Taipei City (TW); SAMAL, Sangram Kumar, 300 Hsinchu City (TW)
(74) Representative: Müller Schupfner & Partner Patent- und Rechtsanwaltspartnerschaft mbB (Muc)

(57) **Abstract**

A liquid multi-nozzle jet-impingement cooling device (100, 104, 100A, 104A) may include microjet multi-nozzle plate (150), outlet plate (130), inlet plate (120), outlet flow plate (160) and cover plate (170). Cover plate is coupled to outlet flow plate, which is coupled to inlet plate, which is coupled to outlet plate, which is coupled to microjet multi-nozzle plate. First inlet through hole (171) of cover plate is fluidly and outlet through hole (178) of sub-outlet plenums (175, 177) of cover plate are respectively fluidly coupled to chamber (155) of microjet multi-nozzle plate. Chamber is sealably mounted on surface of processor (140). Third inlet orifice arrays (153) of microjet multi-nozzle plate directs liquid coolant to surface of processor and first outlet orifice arrays (158) of microjet multi-nozzle plate directs liquid coolant away from surface of processor.

## Description

### Technical Field

The present disclosure relates to heat-transfer components and assemblies, and more particularly, but not limited to, liquid multi-nozzle jet-impingement cooling devices.

### Background

Direct liquid cooling (DLC), cold plate cooling, or direct-to-chip (DTC) cooling, circulates liquid coolant through a chamber of a flat metal plate, such as a cold plate. The flat metal plate is in thermal contact with a heat source, such as a CPU or GPU, and as the liquid coolant flows through the chamber, the liquid coolant absorbs heat generated from the heat source. The heated liquid coolant then exits the chamber and is cooled in a heat exchanger or expelled.

Thermal resistance is the ratio of the difference between the heat source temperature and liquid coolant temperature (°C) divided by a given thermal load (Watt). The lower the thermal resistance, the better the cooling performance at the flat metal plate and heat source level.

Generally, heat source and flat metal plate mating surfaces have microscopic irregularities and roughness. Air gaps between the mating surfaces hinder thermal conduction, thus, increasing thermal resistance. Often, thermal interface materials (TIMs) are used to fill in air gaps between the mating surfaces, improving heat transfer therebetween. O f the different TIMs, thermal paste and thermal grease allows for the removal of the flat metal plate for servicing, maintenance or replacement of components.

However, improper application, thickness, and pressure, may lead to suboptimal thermal performance of the TIMs. Also, natural degradation over time and pump-out for direct die contact may lead the TIMs to no longer effectively transfer heat away from the heat source.

Thus, lowering the thermal resistance at flat metal plate and heat source level, eliminating natural degradation, and preventing pump-out for direct die contact of TIMs, while allowing efficient removal of the flat metal plate for servicing, maintenance or replacement of components continues to remain a challenge.

### SUMMARY

The present disclosure provides a liquid multi-nozzle jet-impingement cooling device with higher heat transfer rate.

The liquid multi-nozzle jet-impingement cooling device for cooling a processor of a first configuration includes a microjet multi-nozzle plate, an outlet plate, an inlet plate, an outlet flow plate and a cover plate. The microjet multi-nozzle plate includes a chamber having a top portion. The top portion includes a plurality of third inlet orifice arrays, a plurality of first outlet orifice arrays, and a bottom opening. The bottom opening is opposite the top portion. The outlet plate is coupled to the microjet multi-nozzle plate. The outlet plate includes an outlet plenum and one or more first outlet channels. The outlet plenum includes an outlet bottom portion having a plurality of flow guide wall structures and a plurality of second outlet orifice arrays. Each plurality of flow guide wall structures includes a second inlet orifice array. The inlet plate is coupled to the outlet plate. The inlet plate includes an inlet plenum and one or more second outlet channels. The outlet flow plate is coupled to the inlet plate. The outlet flow plate includes a second inlet through hole and one or more third outlet channels. The cover plate is coupled to the outlet flow plate. The cover plate includes a first inlet through hole and one or more sub-outlet plenums. Each one or more sub-outlet plenums includes an outlet through hole. The first inlet through hole is centrally disposed through the cover plate. The one or more sub-outlet plenums is disposed at a side of the first inlet through hole and within the cover plate. The first inlet through hole is fluidly coupled to the chamber via the second inlet through hole, the inlet plenum, each second inlet orifice array of the plurality of flow guide wall structures, and the plurality of third inlet orifice arrays. The outlet through hole is fluidly coupled to the chamber via the one or more sub-outlet plenums, the one or more third outlet channels, the one or more second outlet channels, and the plurality of first outlet orifice arrays. The chamber is sealably mounted on a surface of the processor and the plurality of third inlet orifice arrays directs liquid coolant to impinge downwards toward a surface of the processor. The plurality of first outlet orifice arrays directs liquid coolant upward to be transported away from the surface of the processor.

In some aspects, the techniques described herein relate to a liquid multi-nozzle jet-impingement cooling device, wherein the inlet plenum includes an inlet bottom portion. The inlet bottom portion includes a plurality of first inlet orifice arrays. The second inlet through hole is fluidly coupled to each second inlet orifice array of the plurality of flow guide wall structures via the plurality of first inlet orifice arrays.

In some aspects, the techniques described herein relate to a liquid multi-nozzle jet-impingement cooling device, wherein a first inlet orifice of each plurality of first inlet orifice arrays includes a first inlet diameter, a second inlet orifice of each second inlet orifice array includes a second inlet diameter, and a third inlet orifice of the plurality of third inlet orifice arrays includes a third inlet diameter, and wherein a first outlet orifice of each plurality of first outlet orifice arrays includes a first outlet diameter, and a second outlet orifice of each second outlet orifice array includes a second outlet diameter. The first inlet diameter and the second inlet diameter and the third inlet diameter correspond in inlet sizes. The first outlet diameter and the second outlet diameter correspond in outlet sizes. The first inlet diameter and the second inlet diameter and the third inlet diameter is smaller than the first outlet diameter and the second outlet diameter.

In some aspects, the techniques described herein relate to a liquid multi-nozzle jet-impingement cooling device, wherein each plurality of first outlet orifice arrays is between each neighboring plurality of third inlet orifice arrays, and each plurality of second outlet orifice arrays is between each neighboring plurality of flow guide wall structures.

In some aspects, the techniques described herein relate to a liquid multi-nozzle jet-impingement cooling device, wherein the outlet plate further includes a plurality of flow guide channels. The plurality of flow guide channels is defined between each neighboring plurality of flow guide wall structures. The one or more first outlet channels is fluidly coupled to the plurality of second outlet orifice arrays via the plurality of flow guide channels.

In some aspects, the techniques described herein relate to a liquid multi-nozzle jet-impingement cooling device, wherein the microjet multi-nozzle plate further includes a plurality of pin fins. Each plurality of pin fins is between each neighboring plurality of first outlet orifice arrays and plurality of third inlet orifice arrays.

In some aspects, the techniques described herein relate to a liquid multi-nozzle jet-impingement cooling device, wherein the chamber is centrally disposed within the microjet multi-nozzle plate, the outlet plenum is centrally disposed within the outlet plate, and the inlet plenum is centrally disposed within the inlet plate. The one or more first outlet channels is disposed on an outlet perimeter side of the outlet plenum, the one or more second outlet channels is disposed on an inlet perimeter side of the inlet plenum, and the one or more third outlet channels is aligned with the one or more second outlet channels.

In some aspects, the techniques described herein relate to a liquid multi-nozzle jet-impingement cooling device, wherein the one or more first outlet channels includes a first elongated oval-shape and two one or more first outlet channels. The one or more second outlet channels includes a second elongated oval-shape and two one or more second outlet channels. The one or more third outlet channels includes a third elongated oval-shape and two one or more third outlet channels. The one or more sub-outlet plenums includes a quadrilateral shape and two one or more sub-outlet plenums. Each of the two one or more first outlet channels is on opposite first perimeter sides of the outlet plenum. Each of the two one or more second outlet channels is on opposite second perimeter sides of the inlet plenum. Each of the two one or more third outlet channels is respectively aligned with the one or more second outlet channels. Each of the two one or more third outlet channels is respectively aligned within each two one or more sub-outlet plenums.

In some aspects, the techniques described herein relate to a liquid multi-nozzle jet-impingement cooling device, wherein the one or more second outlet channels is not fluidly coupled to the inlet plenum.

In some aspects, the techniques described herein relate to a liquid multi-nozzle jet-impingement cooling device, further including an inlet conduit and one or more outlet conduits. The inlet conduit is disposed through the first inlet through hole and the second inlet through hole. The one or more outlet conduits is disposed through each outlet through hole of the one or more sub-outlet plenums. The inlet conduit is fluidly coupled to the inlet plenum. The one or more outlet conduits fluidly is coupled to the one or more sub-outlet plenums.

In some aspects, the techniques described herein relate to a liquid multi-nozzle jet-impingement cooling device, wherein the inlet conduit includes an input diameter and each one or more outlet conduits includes an outlet diameter. The input diameter is larger than the outlet diameter.

In some aspects, the techniques described herein relate to a liquid multi-nozzle jet-impingement cooling device. The one or more outlet conduits include two one or more outlet conduits. The one or more sub-outlet plenums includes two one or more sub-outlet plenums.

In some aspects, the techniques described herein relate to a liquid multi-nozzle jet-impingement cooling device, wherein the microjet multi-nozzle plate further includes a groove and a sealant member. The bottom opening defines a chamber perimeter and the groove surrounds the chamber perimeter. The sealant member is disposed within the groove to sealably mount the chamber on the surface of the processor.

In some aspects, the techniques described herein relate to a liquid multi-nozzle jet-impingement cooling device, wherein the processor includes a semiconductor device mounted on a printed circuit board.

In some aspects, the techniques described herein relate to a liquid multi-nozzle jet-impingement cooling device, further including a plurality of fasteners for mechanically fixing the liquid multi-nozzle jet-impingement cooling device to the printed circuit board. The cover plate further includes a plurality of cover plate fastener through holes disposed surrounding a sub-outlet perimeter of the one or more sub-outlet plenums. The outlet flow plate further includes a plurality of flow plate fastener through holes disposed surrounding a third perimeter including the one or more third outlet channels. The inlet plate further includes a plurality of inlet plate fastener through holes disposed surrounding a second perimeter including the inlet plenum and the one or more second outlet channels. The outlet plate further includes a plurality of outlet plate fastener through holes disposed surrounding a first perimeter including the outlet plenum and the one or more first outlet channels. The microjet multi-nozzle plate further includes a plurality of nozzle plate fastener through holes disposed surrounding a chamber perimeter of the chamber. The plurality of cover plate fastener through holes align with the plurality of flow plate fastener through holes, which align with the plurality of inlet plate fastener through holes, which align with the plurality of outlet plate fastener through holes, and which align with the plurality of nozzle plate fastener through holes.

### BRIEF DESCRIPTION OF THE DRAWINGS

Unless specified otherwise, the accompanying drawings illustrate aspects of the innovative subject matter described herein. Referring to the drawings, wherein like reference numerals indicate similar parts throughout the several views, several examples of liquid multi-nozzle jet-impingement cooling devices incorporating aspects of the presently disclosed principles are illustrated by way of example, and not by way of limitation.
Fig. 1A illustrates a perspective view of a liquid multi-nozzle jet-impingement cooling device, in accordance with various embodiments of the present disclosure.
Fig. 1B illustrates an exploded view of the liquid multi-nozzle jet-impingement cooling device of Fig. 1A, in accordance with various embodiments of the present disclosure.
Fig. 2 illustrates a perspective view of a cover plate of the liquid multi-nozzle jet-impingement cooling device of Fig. 1A, in accordance with various embodiments of the present disclosure.
Fig. 3 illustrates a perspective view of an outlet flow plate and internal edge view of the cover plate of Fig. 2, in accordance with various embodiments of the present disclosure.
Fig. 4 illustrates another perspective view of the outlet flow plate of Fig. 3 and internal edge view of an inlet plate of the liquid multi-nozzle jet-impingement cooling device of Fig. 1A, in accordance with various embodiments of the present disclosure.
Fig. 5 illustrates a perspective view of an outlet plate of the liquid multi-nozzle jet-impingement cooling device of Fig. 1A, in accordance with various embodiments of the present disclosure.
Fig. 6 illustrates a perspective view of a microjet multi-nozzle plate of the liquid multi-nozzle jet-impingement cooling device of Fig. 1A, in accordance with various embodiments of the present disclosure.
Fig. 7A illustrates an internal edge view of the liquid multi-nozzle jet-impingement cooling device of Fig. 1A and a cross-sectional view A-A' line, in accordance with various embodiments of the present disclosure.
Fig. 7B illustrates a side, cross-sectional view along the A-A' line of the liquid multi-nozzle jet-impingement cooling device of Fig. 7A, in accordance with various embodiments of the present disclosure.
Fig. 8A illustrates an internal edge view of the liquid multi-nozzle jet-impingement cooling device of Fig. 1A and a cross-sectional view B-B' line, in accordance with various embodiments of the present disclosure.
Fig. 8B illustrates a side, cross-sectional view along the B-B' line of the liquid multi-nozzle jet-impingement cooling device of Fig. 8A, in accordance with various embodiments of the present disclosure.
Fig. 9A illustrates a perspective view of another microjet multi-nozzle plate of the liquid multi-nozzle jet-impingement cooling device of Fig. 1A, in accordance with various embodiments of the present disclosure.
Fig. 9B illustrates another perspective view of the another microjet multi-nozzle plate of Fig. 9A, in accordance with various embodiments of the present disclosure.
Fig. 10A illustrates an internal edge view of another liquid multi-nozzle jet-impingement cooling device of Fig. 9A and a cross-sectional view C-C' line, in accordance with various embodiments of the present disclosure.
Fig. 10B illustrates a side, cross-sectional view along the C-C' line of the liquid multi-nozzle jet-impingement cooling device of Fig. 10A, in accordance with various embodiments of the present disclosure.
Fig. 11A illustrates a perspective view of another liquid multi-nozzle jet-impingement cooling device, in accordance with various embodiments of the present disclosure.
Fig. 11B illustrates another perspective view of the liquid multi-nozzle jet-impingement cooling device of Fig. 11A, in accordance with various embodiments of the present disclosure.
Fig. 11C illustrates an exploded view of the liquid multi-nozzle jet-impingement cooling device of Fig. 11A, in accordance with various embodiments of the present disclosure.
Fig. 12 illustrates a perspective view of a cover plate of the liquid multi-nozzle jet-impingement cooling device of Fig. 11A, in accordance with various embodiments of the present disclosure.
Fig. 13 illustrates a perspective view of an outlet flow plate and internal edge view of the cover plate of Fig. 12, in accordance with various embodiments of the present disclosure.
Fig. 14A illustrates an internal edge view of the liquid multi-nozzle jet-impingement cooling device of Fig. 11A and a cross-sectional view A-A' line, in accordance with various embodiments of the present disclosure.
Fig. 14B illustrates a side, cross-sectional view along the D-D' line of the liquid multi-nozzle jet-impingement cooling device of Fig. 14A, in accordance with various embodiments of the present disclosure.
Fig. 15A illustrates an internal edge view of another liquid multi-nozzle jet-impingement cooling device and a cross-sectional view E-E' line, in accordance with various embodiments of the present disclosure.
Fig. 15B illustrates a side, cross-sectional view along the E-E' line of the liquid multi-nozzle jet-impingement cooling device of Fig. 15A, in accordance with various embodiments of the present disclosure.

### DETAILED DESCRIPTION

The following describes various principles related to components and assemblies for processor cooling by way of reference to specific examples of liquid multi-nozzle jet-impingement cooling devices, including specific arrangements and examples of plates and channels embodying innovative concepts. More particularly, but not exclusively, such innovative principles are described in relation to selected examples of inlet orifice arrays directing liquid coolant to impinge downwards toward a surface of a processor and outlet orifice arrays directing liquid coolant upward to be transported away from the surface of the processor, and well-known functions or constructions are not described in detail for purposes of succinctness and clarity. Nonetheless, one or more of the disclosed principles can be incorporated in various other embodiments of different inlet orifice arrays and outlet orifice arrays to achieve any of a variety of desired outcomes, characteristics, and/or performance criteria.

Thus, plates and channels having attributes that are different from those specific examples discussed herein can embody one or more of the innovative principles, and can be used in applications not described herein in detail. Accordingly, embodiments of inlet orifice arrays and outlet orifice arrays not described herein in detail also fall within the scope of this disclosure, as will be appreciated by those of ordinary skill in the relevant art following a review of this disclosure.

Example embodiments as disclosed herein are directed to liquid multi-nozzle jet-impingement cooling devices that can be used in cooling systems, as a part of a cooling loop, to dissipate high heat loads via circulation of a liquid coolant inside of metal plates. The liquid multi-nozzle jet-impingement cooling devices can be used to cool electronic components such as high-performance processors used in data center servers or other types of electronic components that generate high heat loads during use. The processor can include central processing units (CPUs), graphics processing units (GPUs), neural network processing units (NPUs), tensor processing units (TPUs) etc. The liquid coolant is usually a mix of water and glycol, but fluids such as oil, dielectric fluids, custom heat transfer fluids, and the like can also be used. The cooling system can comprise liquid cold plates, cooling lines (tubing and piping), fans, pump(s), and additional heat transfer devices (such as a radiator). Some cooling systems can also comprise manifolds, expansion tank(s), and a cooling distribution unit.

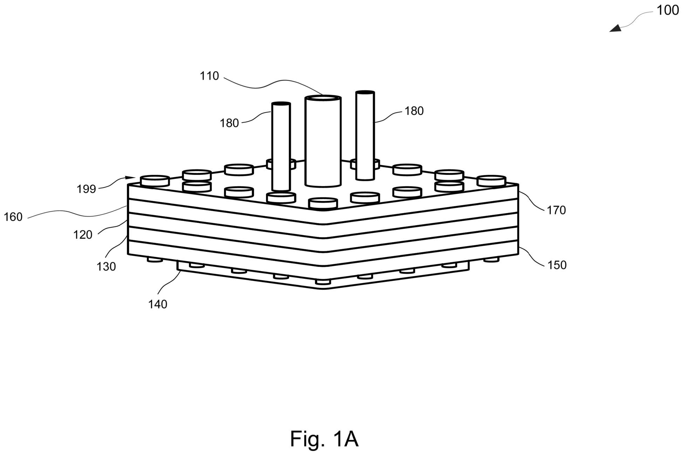

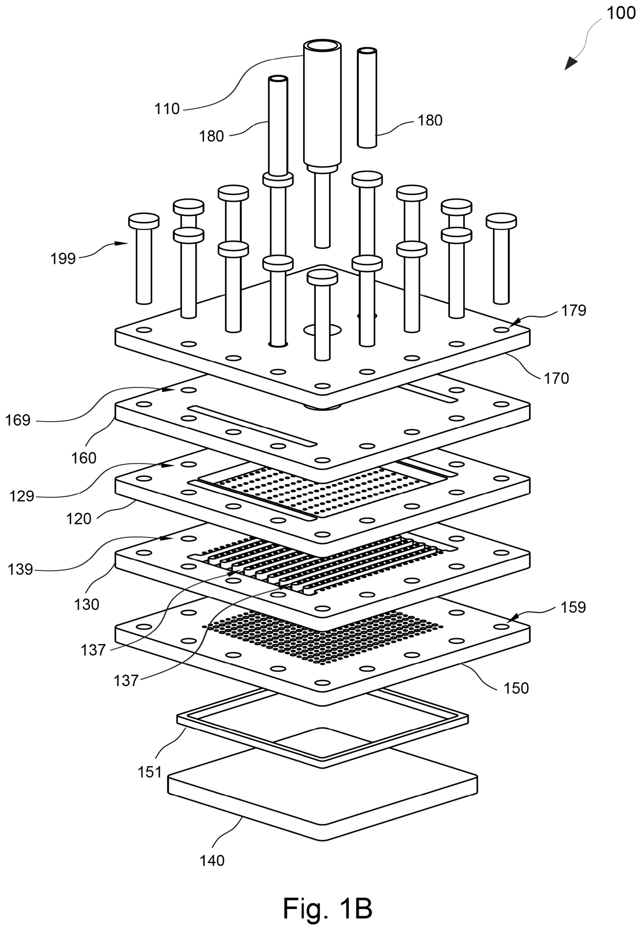

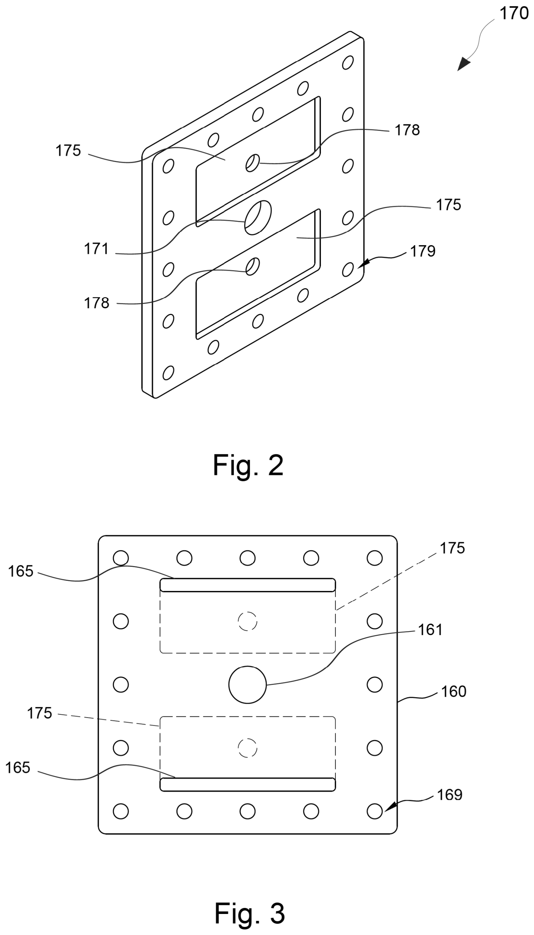

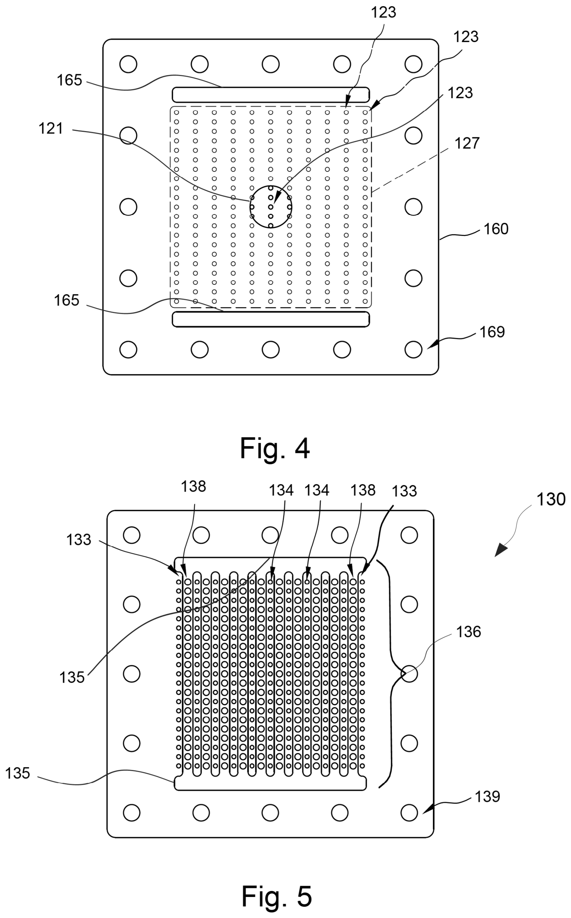

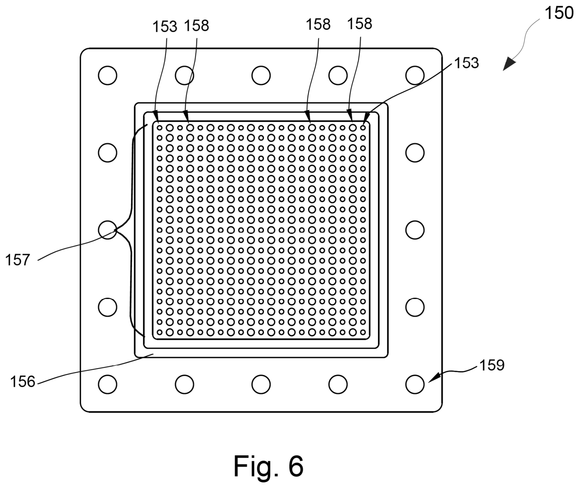

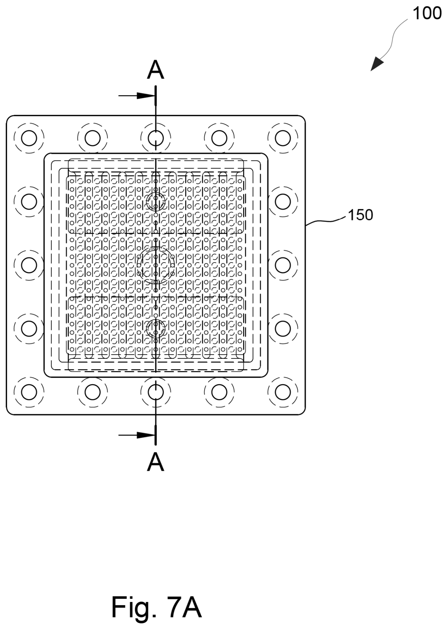

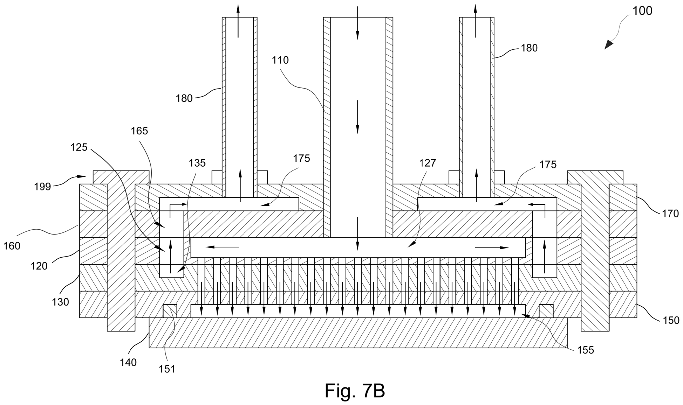

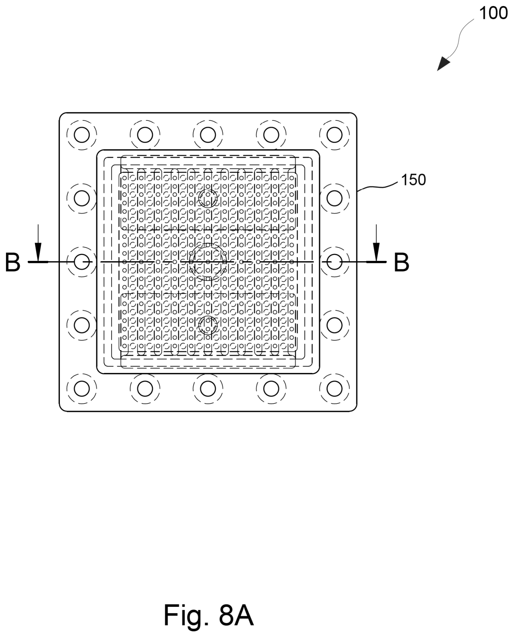

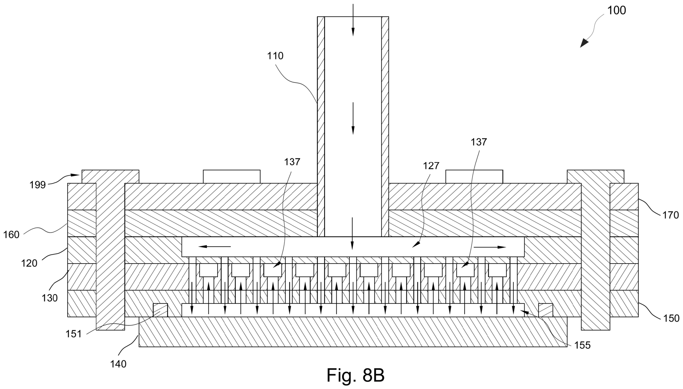

Figs. 1A to 8B illustrate a liquid multi-nozzle jet-impingement cooling device 100, in accordance with various embodiments of the present disclosure. The liquid multi-nozzle jet-impingement cooling device 100 for cooling a processor 140 of a first configuration includes a microjet multi-nozzle plate 150, an outlet plate 130, an inlet plate 120, an outlet flow plate 160 and a cover plate 170. The microjet multi-nozzle plate 150 includes a chamber 155 having a top portion. The top portion includes a plurality of third inlet orifice arrays 153, a plurality of first outlet orifice arrays 158, and a bottom opening 157. The bottom opening 157 is opposite the top portion. The outlet plate 130 is coupled to the microjet multi-nozzle plate 150. The outlet plate 130 includes an outlet plenum 136 and one or more first outlet channels 135. The outlet plenum 136 includes an outlet bottom portion having a plurality of flow guide wall structures 133 and a plurality of second outlet orifice arrays 138. Each plurality of flow guide wall structures 133 includes a second inlet orifice array 134. The inlet plate 120 is coupled to the outlet plate 130. The inlet plate 120 includes an inlet plenum 127 and one or more second outlet channels 125. The outlet flow plate 160 is coupled to the inlet plate 120. The outlet flow plate 160 includes a second inlet through hole 161 and one or more third outlet channels 165. The cover plate 170 is coupled to the outlet flow plate 160. The cover plate 170 includes a first inlet through hole 171 and one or more sub-outlet plenums 175. Each one or more sub-outlet plenums 175 includes an outlet through hole 178. The first inlet through hole 171 is centrally disposed through the cover plate 170. The one or more sub-outlet plenums 175 is disposed at a side of the first inlet through hole 171 and within the cover plate 170. The first inlet through hole 171 is fluidly coupled to the chamber 155 via the second inlet through hole 161, the inlet plenum 127, each second inlet orifice array 134 of the plurality of flow guide wall structures 133, and the plurality of third inlet orifice arrays 153. The outlet through hole 178 is fluidly coupled to the chamber 155 via the one or more sub-outlet plenums 175, the one or more third outlet channels 165, the one or more second outlet channels 125, and the plurality of first outlet orifice arrays 158. The chamber 155 is sealably mounted on a surface of the processor 140 and the plurality of third inlet orifice arrays 153 directs liquid coolant to impinge downwards toward a surface of the processor 140. The plurality of first outlet orifice arrays 158 directs liquid coolant upward to be transported away from the surface of the processor 140.

The microjet multi-nozzle plate 150, the outlet plate 130, the inlet plate 120, the outlet flow plate 160 and the cover plate 170 can be formed with a metal. For example, the material forming the microjet multi-nozzle plate 150, the outlet plate 130, the inlet plate 120, the outlet flow plate 160 and the cover plate 170 can include high thermally conductive metals, such as aluminum, copper, and alloys thereof. Any combination of the microjet multi-nozzle plate 150, the outlet plate 130, the inlet plate 120, the outlet flow plate 160 and the cover plate 170 can be integrally formed. For example, the outlet plate 130, the inlet plate 120, the outlet flow plate 160 and the cover plate 170 can be integrally formed and the microjet multi-nozzle plate 150 can be replaced with newer or custom microjet multi-nozzle plate or for example, the outlet plate 130 and the inlet plate 120 can be integrally formed, the outlet flow plate 160 and the cover plate 170 can be integrally formed, and the outlet flow plate 160/cover plate 170 and the microjet multi-nozzle plate 150 can be respectively replaced with newer or custom outflow plate/cover plate and microjet multi-nozzle plate. The surface of the processor 140 can be a processor die or a heat spreading processor lid (or integrated heat spreader (IHS)). The processor 140 can include a central processing unit, a graphics processing unit, a neural network processing unit, and a tensor processing unit. In some embodiments, the processor 140 includes a semiconductor device mounted on a printed circuit board.

In some embodiments, the inlet plenum 127 includes an inlet bottom portion. The inlet bottom portion includes a plurality of first inlet orifice arrays 123. The second inlet through hole 161 is fluidly coupled to each second inlet orifice array 134 of the plurality of flow guide wall structures 133 via the plurality of first inlet orifice arrays 123.

In some embodiments, each plurality of first outlet orifice arrays 158 is between each neighboring plurality of third inlet orifice arrays 153, and each plurality of second outlet orifice arrays 138 is between each neighboring plurality of flow guide wall structures 133. In some embodiments, the outlet plate 130 further includes a plurality of flow guide channels 137. The plurality of flow guide channels 137 is defined between each neighboring plurality of flow guide wall structures 133. The one or more first outlet channels 135 is fluidly coupled to the plurality of second outlet orifice arrays 138 via the plurality of flow guide channels 137.

In some embodiments, the chamber 155 is centrally disposed within the microjet multi-nozzle plate 150, the outlet plenum 136 is centrally disposed within the outlet plate 130, and the inlet plenum 127 is centrally disposed within the inlet plate 120. The one or more first outlet channels 135 is disposed on an outlet perimeter side of the outlet plenum 136, the one or more second outlet channels 125 is disposed on an inlet perimeter side of the inlet plenum 127, and the one or more third outlet channels 165 is aligned with the one or more second outlet channels 125. In some embodiments, the one or more first outlet channels 135 includes a first elongated oval-shape and two one or more first outlet channels 135. The one or more second outlet channels 125 includes a second elongated oval-shape and two one or more second outlet channels 125. The one or more third outlet channels 165 includes a third elongated oval-shape and two one or more third outlet channels 165. The one or more sub-outlet plenums 175 includes a quadrilateral shape and two one or more sub-outlet plenums 175. Each of the two one or more first outlet channels 135 is on opposite first perimeter sides of the outlet plenum 136. Each of the two one or more second outlet channels 125 is on opposite second perimeter sides of the inlet plenum 127. Each of the two one or more third outlet channels 165 is respectively aligned with the one or more second outlet channels 125. Each of the two one or more third outlet channels 165 is respectively aligned within each two one or more sub-outlet plenums 175. In some embodiments, the one or more second outlet channels 125 is not fluidly coupled to the inlet plenum 127.

In some embodiments, a first inlet orifice of each plurality of first inlet orifice arrays 123 includes a first inlet diameter, a second inlet orifice of each second inlet orifice array 134 includes a second inlet diameter, and a third inlet orifice of the plurality of third inlet orifice arrays 153 includes a third inlet diameter, and wherein a first outlet orifice of each plurality of first outlet orifice arrays 158 includes a first outlet diameter, and a second outlet orifice of each second outlet orifice array includes a second outlet diameter. The first inlet diameter and the second inlet diameter and the third inlet diameter correspond in inlet sizes. The first outlet diameter and the second outlet diameter correspond in outlet sizes. The first inlet diameter and the second inlet diameter and the third inlet diameter is smaller than the first outlet diameter and the second outlet diameter. Each first inlet diameter, second inlet diameter and the third inlet diameter can comprise a diameter within the range of 0.05 to 0.1 millimeters, inclusive. Each first outlet diameter and second outlet diameter can comprise a diameter within the range of 0.05 to 0.1 millimeters, inclusive.

In some embodiments, the first inlet diameter and the second inlet diameter and the third inlet diameter is equal to the first outlet diameter and the second outlet diameter. In some embodiments, the first inlet diameter and the second inlet diameter and the third inlet diameter is larger than the first outlet diameter and the second outlet diameter.

In some embodiments, the liquid multi-nozzle jet-impingement cooling device 100 further includes an inlet conduit 110 and one or more outlet conduits 180. The inlet conduit 110 is disposed through the first inlet through hole 171 and the second inlet through hole 161 to provide liquid coolant to the surface of the processor 140 from a component or device of a cooling system. The one or more outlet conduits 180 is disposed through each outlet through hole 178 of the one or more sub-outlet plenums 175 to transport liquid coolant from the surface of the processor 140 to a component or device of the cooling system to be cooled. The inlet conduit 110 is fluidly coupled to the inlet plenum 127. The one or more outlet conduits 180 fluidly is coupled to the one or more sub-outlet plenums 175. In some embodiments, the inlet conduit 110 includes an input diameter and each one or more outlet conduits 180 includes an outlet diameter. The input diameter is larger than the outlet diameter. In some embodiments, the one or more outlet conduits 180 include two one or more outlet conduits 180. The one or more sub-outlet plenums 175 includes two one or more sub-outlet plenums 175.

In some embodiments, the input diameter is equal to the outlet diameter. In some embodiments, the input diameter is smaller than the outlet diameter.

In some embodiments, the microjet multi-nozzle plate 150 further includes a groove 156 and a sealant member 151. The sealant member 151 is disposed on a side of the microjet multi-nozzle plate 150 located away from the outlet plate 130. The bottom opening 157 defines a chamber perimeter and the groove 156 surrounds the chamber perimeter. The sealant member 151 is disposed within the groove 156 to sealably mount the chamber 155 on the surface of the processor 140. When viewed facing the groove 156, the groove 156 can form a square or rectangle and can be prism shaped, having outer dimensions (width and length) smaller than corresponding dimensions of the surface of the processor 140 having a same shape, and having inner dimensions larger than corresponding dimensions of inside wall surfaces of the chamber 155 having a same shape. When viewed from the top, the microjet multi-nozzle plate 150, the outlet plate 130, the inlet plate 120, the outlet flow plate 160 and the cover plate 170 together can form a square or a rectangle and be prism shaped.

In some aspects, grooves and sealant members can further be disposed surrounding a conduit perimeter of the inlet conduit 110, each one or more outlet conduits 180, each one or more sub-outlet plenums 175, the inlet plenum 127, each one or more second outlet channels 125, the outlet plenum 136 and each one or more first outlet channels 135, and on an opposite side of the perimeter of the bottom opening 157. As an example, the sealant member 151 can be a gasket or any other type of sealant member that fluidic seals the liquid multi-nozzle jet-impingement cooling device 100 on the surface of the processor 140.

In some embodiments, the liquid multi-nozzle jet-impingement cooling device 100 further includes a plurality of fasteners 199 for mechanically fixing the liquid multi-nozzle jet-impingement cooling device 100 to the printed circuit board along a thickness direction. The cover plate 170 further includes a plurality of cover plate fastener through holes 179 disposed surrounding a sub-outlet perimeter of the one or more sub-outlet plenums 175. The outlet flow plate 160 further includes a plurality of flow plate fastener through holes 169 disposed surrounding a third perimeter including the one or more third outlet channels 165. The inlet plate 120 further includes a plurality of inlet plate fastener through holes 129 disposed surrounding a second perimeter including the inlet plenum 127 and the one or more second outlet channels 125. The outlet plate 130 further includes a plurality of outlet plate fastener through holes 139 disposed surrounding a first perimeter including the outlet plenum 136 and the one or more first outlet channels 135. The microjet multi-nozzle plate 150 further includes a plurality of nozzle plate fastener through holes 159 disposed surrounding a chamber perimeter of the chamber 155. The plurality of cover plate fastener through holes 179 align with the plurality of flow plate fastener through holes 169, which align with the plurality of inlet plate fastener through holes 129, which align with the plurality of outlet plate fastener through holes 139, and which align with the plurality of nozzle plate fastener through holes 159.

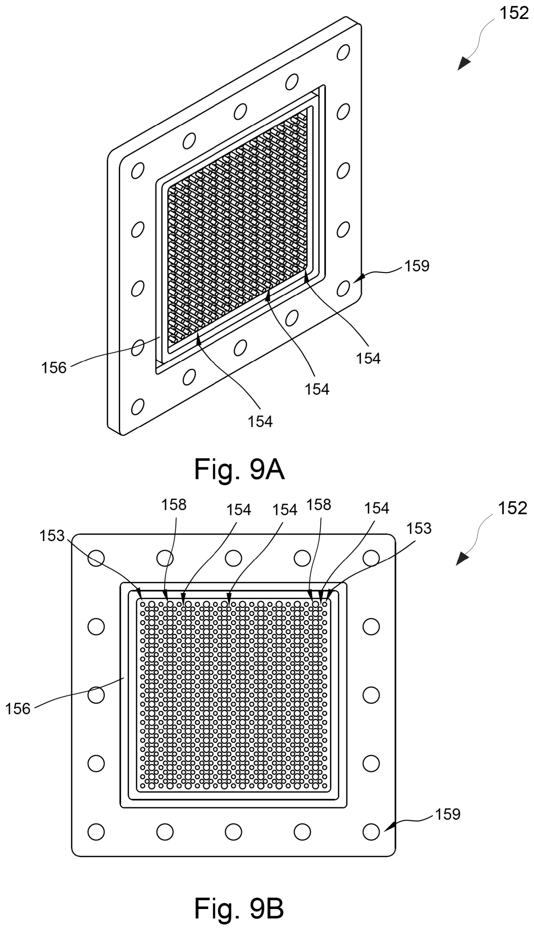

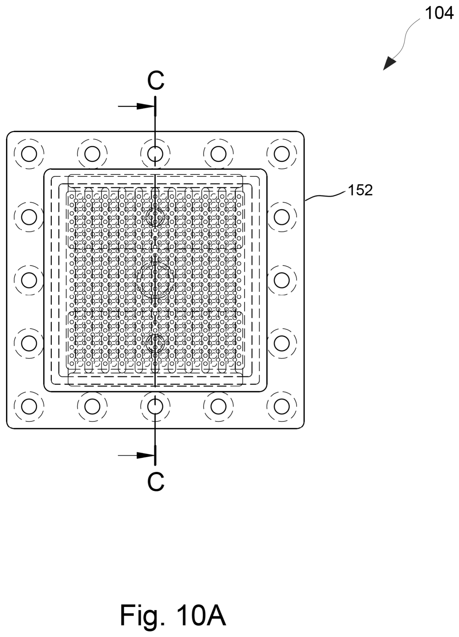

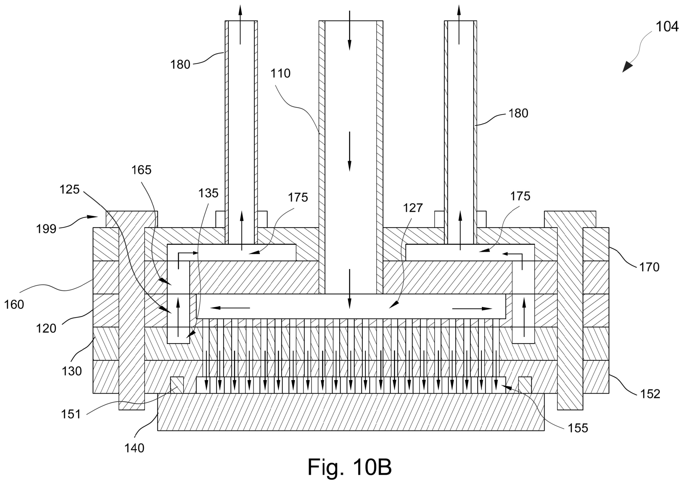

Figs. 9A to 10B illustrate another liquid multi-nozzle jet-impingement cooling device 104, in accordance with various embodiments of the present disclosure. The another liquid multi-nozzle jet-impingement cooling device 104 may be similar in some respects to the liquid multi-nozzle jet-impingement cooling device 100 of Figs. 1A to 8B, and therefore may be best understood with reference thereto where like numerals designate like components not described again in detail. In some embodiments, the microjet multi-nozzle plate 152 further includes a plurality of pin fins 154. Each plurality of pin fins 154 is between each neighboring plurality of first outlet orifice arrays 158 and plurality of third inlet orifice arrays 153. The plurality of pin fins 154 is substantially perpendicular to the processor 140 and is configured to enable low thermal resistance. For example, cross-sectional shapes of the one or more pin fins can include circular, ellipse, diamond, square and triangular shapes. The plurality of pin fins 154 enhance heat transfer, and support a predetermined height of the chamber 155 above the surface of the processor 140.

During operation, liquid coolant is pumped through the first inlet through hole 171 and the second inlet through hole 161, via the inlet conduit 110, into a center of the inlet plenum 127 and across a bottom surface of the inlet plenum 127. The liquid coolant is then forced though the plurality of third inlet orifice arrays 153 via each second inlet orifice array 134 of the plurality of flow guide wall structures 133 aligned with the plurality of third inlet orifice arrays 153 and the first plurality of inlet orifice arrays aligned with each second inlet orifice array 134 of the plurality of flow guide wall structures 133. The liquid coolant then enters the chamber 155 and impinges upon the surface of the processor 140, absorbing heat from the processor 140. In some embodiments including the plurality of pin fins 154, the liquid coolant passes by the plurality of pin fins 154, whereby the plurality of pin fins 154 increase the heat transfer surface area and promote flow mixing, thus, enhancing heat transfer. Next, the heated liquid coolant is forced through the plurality of second outlet orifice arrays 138 via the plurality of first outlet orifice arrays 158 aligned with the plurality of second outlet orifice arrays 138. The heated liquid coolant then travels through the plurality of flow guide channels 137 to the one or more first outlet channels 135, and then to the one or more sub-outlet plenums 175 via the one or more second outlet channels 125 aligned with the one or more first outlet channels 135 and the one or more third outlet channels 165 aligned with the one or more second outlet channels 125. The heated liquid coolant flows out of the liquid multi-nozzle jet-impingement cooling device 100/104 through the one or more outlet through holes 178 via the one or more outlet conduits 180.

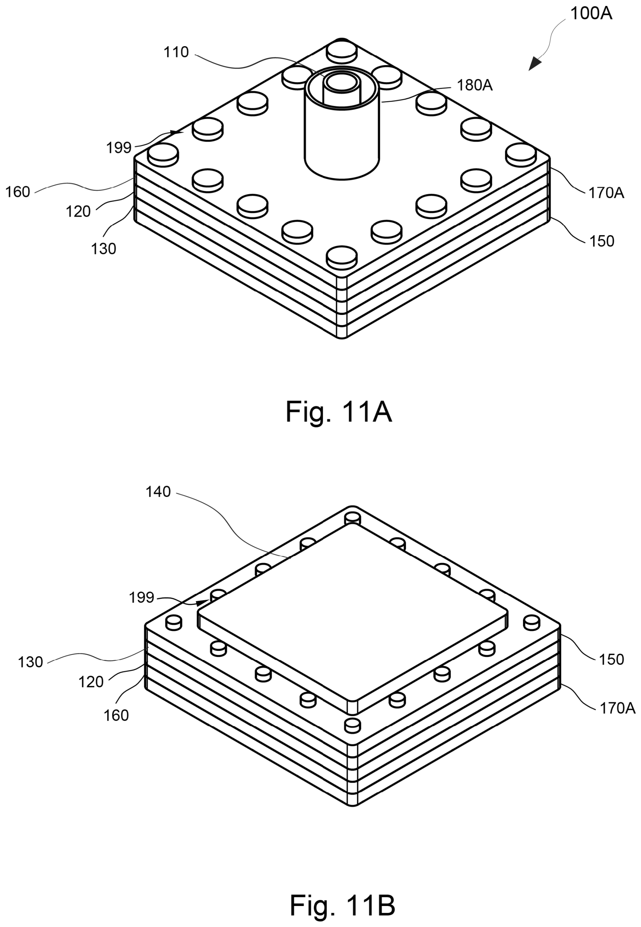

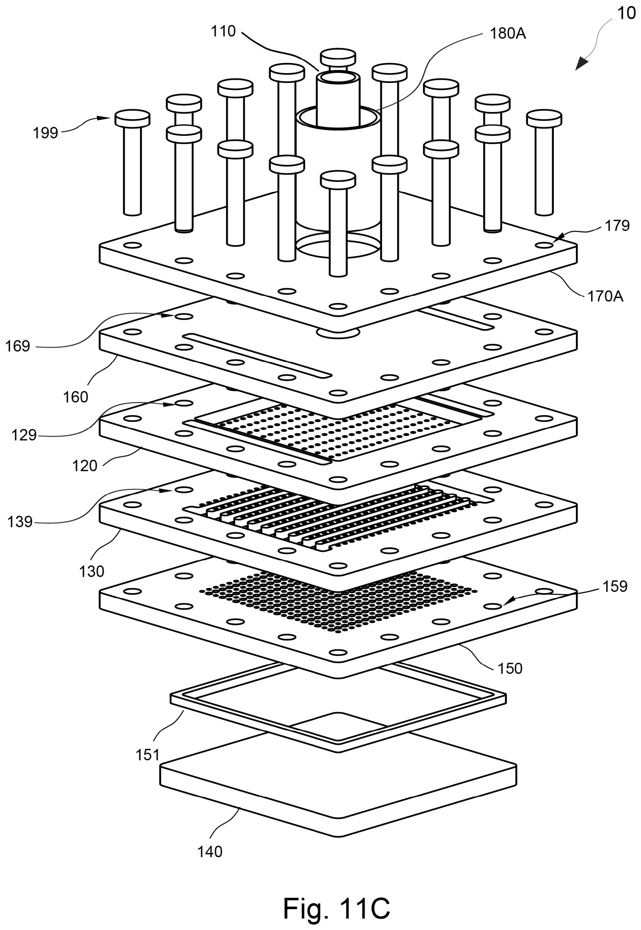

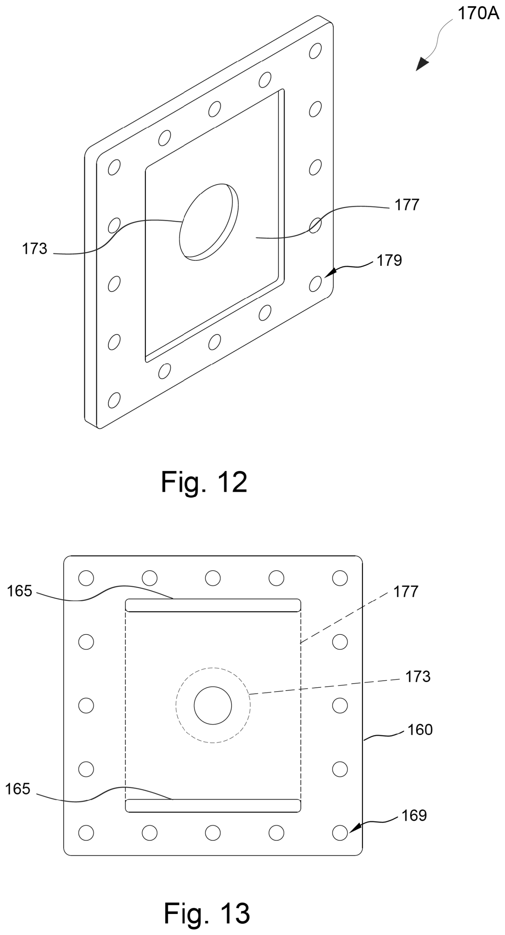

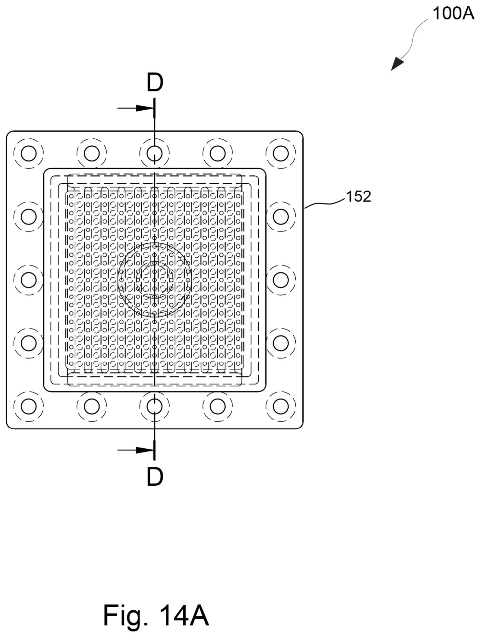

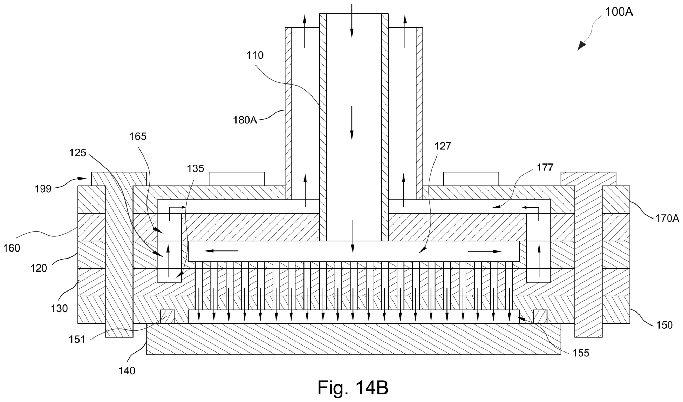

Figs. 11A to 14B illustrate yet another liquid multi-nozzle jet-impingement cooling device 100A, in accordance with various embodiments of the present disclosure. The another liquid multi-nozzle jet-impingement cooling device 100A may be similar in some respects to the liquid multi-nozzle jet-impingement cooling device 100 of Figs. 1A to 8B, and therefore may be best understood with reference thereto where like numerals designate like components not described again in detail. The liquid multi-nozzle jet-impingement cooling device 100A for cooling a processor 140 of a second configuration includes a microjet multi-nozzle plate 150, an outlet plate 130, an inlet plate 120, an outlet flow plate 160 and a modified cover plate 170A. The microjet multi-nozzle plate 150 includes a chamber 155 having a top portion. The top portion includes a plurality of third inlet orifice arrays 153, a plurality of first outlet orifice arrays 158, and a bottom opening 157. The bottom opening 157 is opposite the top portion. The outlet plate 130 is coupled to the microjet multi-nozzle plate 150. The outlet plate 130 includes an outlet plenum 136 and one or more first outlet channels 135. The outlet plenum 136 includes an outlet bottom portion having a plurality of flow guide wall structures 133 and a plurality of second outlet orifice arrays 138. Each plurality of flow guide wall structures 133 includes a second inlet orifice array 134. The inlet plate 120 is coupled to the outlet plate 130. The inlet plate 120 includes an inlet plenum 127 and one or more second outlet channels 125. The outlet flow plate 160 is coupled to the inlet plate 120. The outlet flow plate 160 includes a second inlet through hole 161 and one or more third outlet channels 165. The modified cover plate 170A is coupled to the outlet flow plate 160. The modified cover plate 170A includes a combined through hole 173 and a modified sub-outlet plenum 177. The combined through hole 173 is centrally disposed through the modified cover plate 170A and the modified sub-outlet plenum 177. The modified sub-outlet plenum 177 is centrally disposed and within the modified cover plate 170A. The combined through hole 173 is fluidly coupled to the chamber 155 via an inlet conduit 110 disposed through the combined through hole 173 and the second inlet through hole 161, to the inlet plenum 127, through each second inlet orifice array 134 of the plurality of flow guide wall structures 133, and through the plurality of third inlet orifice arrays 153. The combined through hole 173 is fluidly coupled to the chamber 155 via a modified outlet conduit 180A disposed surrounding the inlet conduit 110 and through the combined through hole 173, to the modified sub-outlet plenum 177, through the one or more third outlet channels 165, through the one or more second outlet channels 125, and through the plurality of first outlet orifice arrays 158. The inlet conduit 110 is disposed through the combined through hole 173 and the second inlet through hole 161 to provide liquid coolant to the surface of the processor 140 from a component or device of a cooling system. The modified outlet conduit 180A is disposed through the combined through hole 173 to transport liquid coolant from the surface of the processor 140 to a component or device of the cooling system to be cooled. The inlet conduit 110 is fluidly coupled to the inlet plenum 127. The modified outlet conduit 180A is fluidly coupled to the modified sub-outlet plenum 177. The chamber 155 is sealably mounted on a surface of the processor 140 and the plurality of third inlet orifice arrays 153 directs liquid coolant to impinge downwards toward a surface of the processor 140. The plurality of first outlet orifice arrays 158 directs liquid coolant upward to be transported away from the surface of the processor 140. In some embodiments, the processor 140 includes a semiconductor device mounted on a printed circuit board.

In some embodiments, the inlet plenum 127 includes an inlet bottom portion. The inlet bottom portion includes a plurality of first inlet orifice arrays 123. The second inlet through hole 161 is fluidly coupled to each second inlet orifice array 134 of the plurality of flow guide wall structures 133 via the plurality of first inlet orifice arrays 123.

In some embodiments, each plurality of first outlet orifice arrays 158 is between each neighboring plurality of third inlet orifice arrays 153, and each plurality of second outlet orifice arrays 138 is between each neighboring plurality of flow guide wall structures 133. In some embodiments, the outlet plate 130 further includes a plurality of flow guide channels 137. The plurality of flow guide channels 137 is defined between each neighboring plurality of flow guide wall structures 133. The one or more first outlet channels 135 is fluidly coupled to the plurality of second outlet orifice arrays 138 via the plurality of flow guide channels 137.

In some embodiments, the chamber 155 is centrally disposed within the microjet multi-nozzle plate 150, the outlet plenum 136 is centrally disposed within the outlet plate 130, and the inlet plenum 127 is centrally disposed within the inlet plate 120. The one or more first outlet channels 135 is disposed on an outlet perimeter side of the outlet plenum 136, the one or more second outlet channels 125 is disposed on an inlet perimeter side of the inlet plenum 127, and the one or more third outlet channels 165 is aligned with the one or more second outlet channels 125. In some embodiments, the one or more first outlet channels 135 includes a first elongated oval-shape and two one or more first outlet channels 135. The one or more second outlet channels 125 includes a second elongated oval-shape and two one or more second outlet channels 125. The one or more third outlet channels 165 includes a third elongated oval-shape and two one or more third outlet channels 165. The modified sub-outlet plenum 177 includes a quadrilateral shape and two a modified sub-outlet plenum 177. Each of the two one or more first outlet channels 135 is on opposite first perimeter sides of the outlet plenum 136. Each of the two one or more second outlet channels 125 is on opposite second perimeter sides of the inlet plenum 127. Each of the two one or more third outlet channels 165 is respectively aligned with the one or more second outlet channels 125. Each of the two one or more third outlet channels 165 is respectively aligned within each two a modified sub-outlet plenum 177. In some embodiments, the one or more second outlet channels 125 is not fluidly coupled to the inlet plenum 127.

In some embodiments, a first inlet orifice of each plurality of first inlet orifice arrays 123 includes a first inlet diameter, a second inlet orifice of each second inlet orifice array 134 includes a second inlet diameter, and a third inlet orifice of the plurality of third inlet orifice arrays 153 includes a third inlet diameter, and wherein a first outlet orifice of each plurality of first outlet orifice arrays 158 includes a first outlet diameter, and a second outlet orifice of each second outlet orifice array includes a second outlet diameter. The first inlet diameter and the second inlet diameter and the third inlet diameter correspond in inlet sizes. The first outlet diameter and the second outlet diameter correspond in outlet sizes. The first inlet diameter and the second inlet diameter and the third inlet diameter is smaller than the first outlet diameter and the second outlet diameter.

In some embodiments, the first inlet diameter and the second inlet diameter and the third inlet diameter is equal to the first outlet diameter and the second outlet diameter. In some embodiments, the first inlet diameter and the second inlet diameter and the third inlet diameter is larger than the first outlet diameter and the second outlet diameter.

In some embodiments, the microjet multi-nozzle plate 150 further includes a groove 156 and a sealant member 151. The bottom opening 157 defines a chamber perimeter and the groove 156 surrounds the chamber perimeter. The sealant member 151 is disposed within the groove 156 to sealably mount the chamber 155 on the surface of the processor 140.

In some embodiments, the liquid multi-nozzle jet-impingement cooling device 100 further includes a plurality of fasteners 199 for mechanically fixing the liquid multi-nozzle jet-impingement cooling device 100 to the printed circuit board. The modified cover plate 170A further includes a plurality of modified cover plate fastener through holes 179 disposed surrounding a sub-outlet perimeter of the modified sub-outlet plenum 177. The outlet flow plate 160 further includes a plurality of flow plate fastener through holes 169 disposed surrounding a third perimeter including the one or more third outlet channels 165. The inlet plate 120 further includes a plurality of inlet plate fastener through holes 129 disposed surrounding a second perimeter including the inlet plenum 127 and the one or more second outlet channels 125. The outlet plate 130 further includes a plurality of outlet plate fastener through holes 139 disposed surrounding a first perimeter including the outlet plenum 136 and the one or more first outlet channels 135. The microjet multi-nozzle plate 150 further includes a plurality of nozzle plate fastener through holes 159 disposed surrounding a chamber perimeter of the chamber 155. The plurality of modified cover plate fastener through holes 179 align with the plurality of flow plate fastener through holes 169, which align with the plurality of inlet plate fastener through holes 129, which align with the plurality of outlet plate fastener through holes 139, and which align with the plurality of nozzle plate fastener through holes 159.

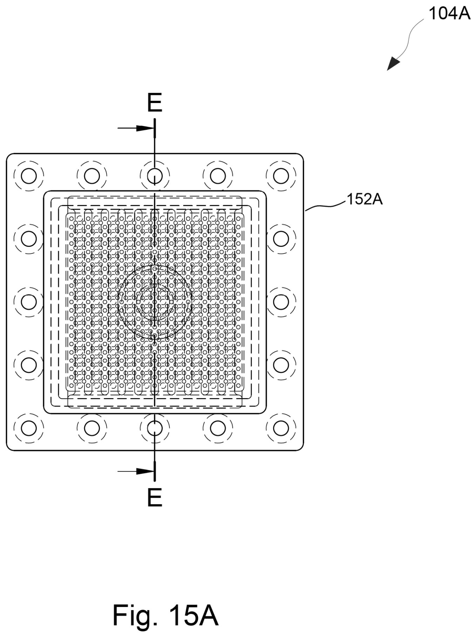

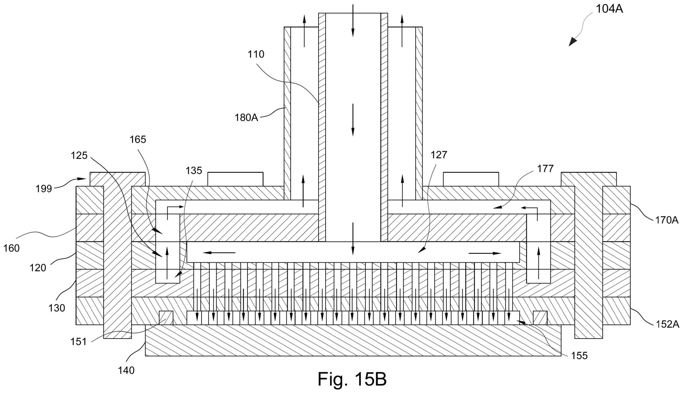

Figs. 15A and 15B illustrate further yet another liquid multi-nozzle jet-impingement cooling device 104A, in accordance with various embodiments of the present disclosure. The another liquid multi-nozzle jet-impingement cooling device 104A may be similar in some respects to the liquid multi-nozzle jet-impingement cooling device 104 of Figs. 9A to 10B, and therefore may be best understood with reference thereto where like numerals designate like components not described again in detail. In some embodiments, the microjet multi-nozzle plate 152 further includes a plurality of pin fins 154. Each plurality of pin fins 154 is between each neighboring plurality of first outlet orifice arrays 158 and plurality of third inlet orifice arrays 153.

During operation, liquid coolant is pumped through the combined through hole 173 and the second inlet through hole 161, via the inlet conduit 110, into a center of the inlet plenum 127 and across a bottom surface of the inlet plenum 127. The liquid coolant is then forced though the plurality of third inlet orifice arrays 153 via each second inlet orifice array 134 of the plurality of flow guide wall structures 133 aligned with the plurality of third inlet orifice arrays 153 and the first plurality of inlet orifice arrays aligned with each second inlet orifice array 134 of the plurality of flow guide wall structures 133. The liquid coolant then enters the chamber 155 and impinges upon the surface of the processor 140, absorbing heat from the processor 140. In some embodiments including the plurality of pin fins 154, the liquid coolant passes by the plurality of pin fins 154, whereby the plurality of pin fins 154 increase the heat transfer surface area and promote flow mixing, thus, enhancing heat transfer. Next, the heated liquid coolant is forced through the plurality of second outlet orifice arrays 138 via the plurality of first outlet orifice arrays 158 aligned with the plurality of second outlet orifice arrays 138. The heated liquid coolant then travels through the plurality of flow guide channels 137 to the one or more first outlet channels 135, and then to the modified sub-outlet plenum 177 via the one or more second outlet channels 125 aligned with the one or more first outlet channels 135 and the one or more third outlet channels 165 aligned with the one or more second outlet channels 125. The heated liquid coolant flows out of the liquid multi-nozzle jet-impingement cooling device 104A through the combined through hole 173 via the modified outlet conduit 180A.

Heat transfer rates of the liquid multi-nozzle jet-impingement cooling devices 100/100A/104/104A of the present disclosure are higher with the elimination of additional layers between the surface of the processor 140 and the liquid coolant. The liquid multi-nozzle jet-impingement cooling devices 100/100A/104/104A mount directly to the surface of the processor 140, eliminating TIMs and/or additional layers which reduce heat transfer effectiveness. The hermetically sealed chamber 155 creates a flow path such that jets of liquid coolant are able to impinge downwards to the surface of the processor 140, while preventing the liquid coolant from leaking onto any electrical connections of the processor 140 or electronics system including the processor 140, which would cause an electrical short or damage. Moreover, with the inlet conduit 110 centrally disposed, the highest flow rate of impingement jets is toward a center of the surface of the processor 140 having a highest heat flux. Thus, heat transfer rates at the highest heat flux area of the processor 140 is increased for more effective heat transfer. Also, two one or more outlet conduits 180 further increases flow rate of the liquid multi-nozzle jet-impingement cooling devices 100/100A/104/104A. Furthermore, the plurality of pin fins 154 further improves cooling and the ability to absorb heat from the processor 140 and transfer it to the liquid coolant. Even furthermore, the liquid multi-nozzle jet-impingement cooling devices 100/100A/104/104A have quick, simple, and safe fixing and removal processes via fastening and unfastening of the plurality of fasteners 199. Additionally, any combination of the microjet multi-nozzle plate 152, the outlet plate 130, the inlet plate 120, the outlet flow plate 160 and the cover plate 170 can be individual formed, for ease of maintenance and repair and/or replacement with newer or custom plates. TIMs and/or additional layers are eliminated, and liquid coolant flow rate are raised, increasing heat transfer rates and enhancing the effectiveness of the liquid multi-nozzle jet-impingement cooling devices 100/100A/104/104A of the present disclosure.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A liquid multi-nozzle jet-impingement cooling device (100, 104, 100A, 104A) for cooling a processor (140), comprising:
a microjet multi-nozzle plate (150) including a chamber (155), the chamber comprises a top portion including a plurality of third inlet orifice arrays (153), a plurality of first outlet orifice arrays (158), and a bottom opening (157), the bottom opening opposite the top portion;
an outlet plate (130) coupled to the microjet multi-nozzle plate, the outlet plate includes an outlet plenum (136) and one or more first outlet channels (135), the outlet plenum comprises an outlet bottom portion, the outlet bottom portion includes a plurality of flow guide wall structures (133) and a plurality of second outlet orifice arrays (138), each plurality of flow guide wall structures comprises a second inlet orifice array (134);
an inlet plate (120) coupled to the outlet plate, the inlet plate includes an inlet plenum (127) and one or more second outlet channels (125);
an outlet flow plate (160) coupled to the inlet plate, the outlet flow plate includes a second inlet through hole (161) and one or more third outlet channels (165); and
a cover plate (170) coupled to the outlet flow plate, the cover plate includes a first inlet through hole (171) and one or more sub-outlet plenums (175, 177), each one or more sub-outlet plenums comprises an outlet through hole (178), the first inlet through hole centrally disposed through the cover plate, the one or more sub-outlet plenums disposed at a side of the first inlet through hole and within the cover plate,
wherein the first inlet through hole is fluidly coupled to the chamber via the second inlet through hole, the inlet plenum, each second inlet orifice array of the plurality of flow guide wall structures, and the plurality of third inlet orifice arrays,
wherein the outlet through hole is fluidly coupled to the chamber via the one or more sub-outlet plenums, the one or more third outlet channels, the one or more second outlet channels, and the plurality of first outlet orifice arrays, and
wherein the chamber is sealably mounted on a surface of the processor and the plurality of third inlet orifice arrays directs a liquid coolant to impinge downwards toward the surface of the processor and the plurality of first outlet orifice arrays directs the liquid coolant upward to be transported away from the surface of the processor.

2. The liquid multi-nozzle jet-impingement cooling device as claimed in claim 1, wherein the inlet plenum comprises an inlet bottom portion, the inlet bottom portion includes a plurality of first inlet orifice arrays (123), the second inlet through hole fluidly coupled to each second inlet orifice array of the plurality of flow guide wall structures via the plurality of first inlet orifice arrays.

3. The liquid multi-nozzle jet-impingement cooling device as claimed in claim 2, wherein a first inlet orifice of each plurality of first inlet orifice arrays comprises a first inlet diameter, a second inlet orifice of each second inlet orifice array comprises a second inlet diameter, and a third inlet orifice of the plurality of third inlet orifice arrays comprises a third inlet diameter, and wherein a first outlet orifice of each plurality of first outlet orifice arrays comprises a first outlet diameter, and a second outlet orifice of each second outlet orifice array comprises a second outlet diameter, the first inlet diameter and the second inlet diameter and the third inlet diameter correspond in inlet sizes, the first outlet diameter and the second outlet diameter correspond in outlet sizes, the first inlet diameter and the second inlet diameter and the third inlet diameter is smaller than the first outlet diameter and the second outlet diameter.

4. The liquid multi-nozzle jet-impingement cooling device as claimed in claim 1, wherein each plurality of first outlet orifice arrays is between each neighboring plurality of third inlet orifice arrays, and each plurality of second outlet orifice arrays is between each neighboring plurality of flow guide wall structures.

5. The liquid multi-nozzle jet-impingement cooling device as claimed in claim 4, wherein the outlet plate further includes a plurality of flow guide channels (137), the plurality of flow guide channels defined between each neighboring plurality of flow guide wall structures, the one or more first outlet channels fluidly coupled to the plurality of second outlet orifice arrays via the plurality of flow guide channels.

6. The liquid multi-nozzle jet-impingement cooling device as claimed in claim 4, wherein the microjet multi-nozzle plate further includes a plurality of pin fins (154), and wherein each plurality of pin fins is between each neighboring plurality of first outlet orifice arrays and the plurality of third inlet orifice arrays.

7. The liquid multi-nozzle jet-impingement cooling device as claimed in claim 1, wherein the chamber is centrally disposed within the microjet multi-nozzle plate, the outlet plenum is centrally disposed within the outlet plate, and the inlet plenum is centrally disposed within the inlet plate, and wherein the one or more first outlet channels is disposed on an outlet perimeter side of the outlet plenum, the one or more second outlet channels is disposed on an inlet perimeter side of the inlet plenum, and the one or more third outlet channels is aligned with the one or more second outlet channels.

8. The liquid multi-nozzle jet-impingement cooling device as claimed in claim 1, wherein the one or more first outlet channels comprises a first elongated oval-shape and two one or more first outlet channels, wherein the one or more second outlet channels comprises a second elongated oval-shape and two one or more second outlet channels, wherein the one or more third outlet channels comprises a third elongated oval-shape and two one or more third outlet channels, and wherein the one or more sub-outlet plenums comprises a quadrilateral shape and two one or more sub-outlet plenums, each of the two one or more first outlet channels is on opposite first perimeter sides of the outlet plenum, each of the two one or more second outlet channels is on opposite second perimeter sides of the inlet plenum, each of the two one or more third outlet channels is respectively aligned with the one or more second outlet channels, and each of the two one or more third outlet channels is respectively aligned within each two one or more sub-outlet plenums.

9. The liquid multi-nozzle jet-impingement cooling device as claimed in claim 1, wherein the one or more second outlet channels is not fluidly coupled to the inlet plenum.

10. The liquid multi-nozzle jet-impingement cooling device as claimed in claim 1, further comprising an inlet conduit (110) and one or more outlet conduits (180, 180A), the inlet conduit is disposed through the first inlet through hole and the second inlet through hole, the one or more outlet conduits is disposed through each outlet through hole of the one or more sub-outlet plenums, the inlet conduit fluidly coupled to the inlet plenum, the one or more outlet conduits fluidly coupled to the one or more sub-outlet plenums.

11. The liquid multi-nozzle jet-impingement cooling device as claimed in claim 10, wherein the inlet conduit comprises an input diameter and each one or more outlet conduits comprises an outlet diameter, the input diameter larger than the outlet diameter.

12. The liquid multi-nozzle jet-impingement cooling device as claimed in claim 10, wherein the one or more outlet conduits comprise two one or more outlet conduits, and wherein the one or more sub-outlet plenums comprises two one or more sub-outlet plenums.

13. The liquid multi-nozzle jet-impingement cooling device as claimed in claim 1, wherein the microjet multi-nozzle plate further includes a groove (156) and a sealant member (151), and wherein the bottom opening defines a chamber perimeter, the groove surrounds the chamber perimeter, the sealant member is disposed within the groove to sealably mount the chamber on the surface of the processor.

14. The liquid multi-nozzle jet-impingement cooling device as claimed in claim 1, wherein the processor comprises a semiconductor device mounted on a printed circuit board.

15. The liquid multi-nozzle jet-impingement cooling device as claimed in claim 14, further comprising a plurality of fasteners (199) for mechanically fixing the liquid multi-nozzle jet-impingement cooling device to the printed circuit board, and wherein the cover plate further includes a plurality of cover plate fastener through holes (179) disposed surrounding a sub-outlet perimeter of the one or more sub-outlet plenums, the outlet flow plate further includes a plurality of flow plate fastener through holes (169) disposed surrounding a third perimeter including the one or more third outlet channels, the inlet plate further includes a plurality of inlet plate fastener through holes (129) disposed surrounding a second perimeter including the inlet plenum and the one or more second outlet channels, the outlet plate further includes a plurality of outlet plate fastener through holes (139) disposed surrounding a first perimeter including the outlet plenum and the one or more first outlet channels, and the microjet multi-nozzle plate further includes a plurality of nozzle plate fastener through holes (159) disposed surrounding a chamber perimeter of the chamber, the plurality of cover plate fastener through holes align with the plurality of flow plate fastener through holes, the plurality of flow plate fastener through holes align with the plurality of inlet plate fastener through holes, the plurality of inlet plate fastener through holes align with the plurality of outlet plate fastener through holes, and the plurality of outlet plate fastener through holes align with the plurality of nozzle plate fastener through holes.
